# EUROPEAN PATENT SPECIFICATION

(11) **EP 1 811 652 B1**
(45) Date of publication and mention of the grant of the patent: **27.03.2019**
(21) Application number: 07000516.0
(22) Date of filing: 11.01.2007
(51) Int. Cl.: H03F 1/34, H03F 1/08, H03F 3/45

(54) **Nested transimpedance amplifier**
Transimpedanzverstärker mit Verschachtelungsschleifen
Amplificateur à transimpédance avec des boucles imbriquées

(30) Priority: 18.01.2006 US 759899 P; 08.05.2006 US 798567 P; 08.05.2006 US 798480 P; 29.06.2006 US 817268 P; 28.07.2006 US 495813; 21.12.2006 US 643089; 21.12.2006 US 643432
(43) Date of publication of application: 25.07.2007
(73) Proprietor: Marvell World Trade Ltd., St. Michael 14027 (BB)
(72) Inventor: Sutardja, Sehat, Los Altos Hills California 94022 (US)
(74) Representative: Grünecker Patent- und Rechtsanwälte PartG mbB

(56) References cited:
- US-B1- 6 552 605
- US-B1- 6 762 644
- CHIK F M ET AL: "Wsign and ahalysis of a broad band transimpedance amplifier" MICROWAVE AND MILLIMETER WAVE TECHNOLOGY, 2004. ICMMT 4TH INTERNATIONA L CONFERENCE ON, PROCEEDINGS BEIJING, CHINA AUG. 18-21, 2004, PISCATAWAY, NJ, USA,IEEE, 18 August 2004 (2004-08-18), pages 296-299, XP010797722 ISBN: 978-0-7803-8401-9

## Description

### CROSS-REFERENCE TO RELATED APPLICATIONS

This application is a continuation of United States Patent Application No. 11/495,813, filed July 28, 2006, which application claims the benefit of U.S. Provisional Application No. 60/817,268, filed on June 29, 2006, 60/798,480, filed May 8, 2006, 60/798,567, filed on May 8, 2006, and 60/759,899, filed on January 18, 2006, and is a continuation-in-part of United States Patent Application No. 10/459,731 filed on June 11, 2003, which is a continuation-in-part of United States Patent No. 6,762,644 issued on July 13, 2004, which claims the benefit of U.S. Provisional Application No. 60/275,109, filed March 13, 2001.

### FIELD OF THE INVENTION

The present invention relates to transimpedance amplifiers, and more particularly to nested transimpedance amplifiers with an increased gain-bandwidth product.

### BACKGROUND OF THE INVENTION

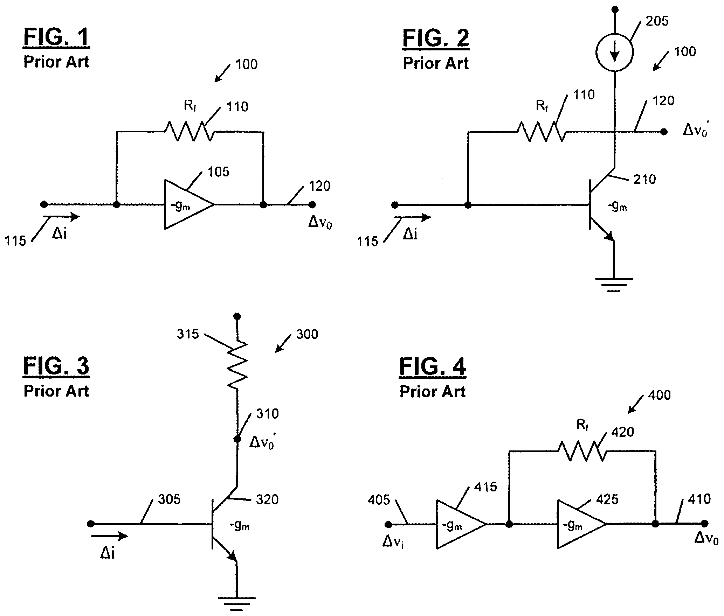

A transimpedance amplifier (TIA) is a well-known type of electronic circuit. Referring now to FIG. 1, a TIA 100 includes an operational amplifier (opamp) 105 having a gain parameter (-gₘ). The opamp 105 is connected in parallel to a resistor (R_{f}) 110. The input to the TIA 100 is a current (Δi) 115. The output of the TIA 100 is a voltage (Δvₒ) 120.

Referring now to FIG. 2, the opamp 105 of the TIA 100 is replaced by a current source 205 and a transistor 210 having gain -gₘ. The TIA 100 in FIGs. 1 and 2 is often referred to as a transconductance amplifier because it converts the input current Δi into the output voltage Δvₒ.

Referring now to FIG. 3, a TIA 300 converts an input voltage (Δvᵢ) 305 into an output voltage (Δvₒ) 310. The TIA 300 also includes a resistor 315 that is connected to a transistor 320. The TIA 300 is typically used in applications that require relatively low bandwidth.

Referring now to FIG. 4, a TIA 400 converts an input voltage (Δvᵢ) 405 into an output voltage (Δvₒ) 410. The TIA 400 includes a second opamp 415, which is connected in series to a parallel combination of a resistor (R_{f}) 420 and an opamp 425. The TIA 400 is typically used for applications having higher bandwidth requirements than the TIA 300.

Ordinarily, the bandwidth of the TIA is limited to a fraction of a threshold frequency f_{T} of transistor(s) that are used in the opamp(s). In the case of a bipolar junction transistor (BJT) such as a gallium-arsenide (GaAs) transistor, the bandwidth of the TIA is approximately equal to 10%-20% of f_{T}. For metal-oxide-semiconductor (MOS) transistors), the bandwidth of the TIA is typically a few percent (i.e., approximately 2%-6%) of f_{T}.

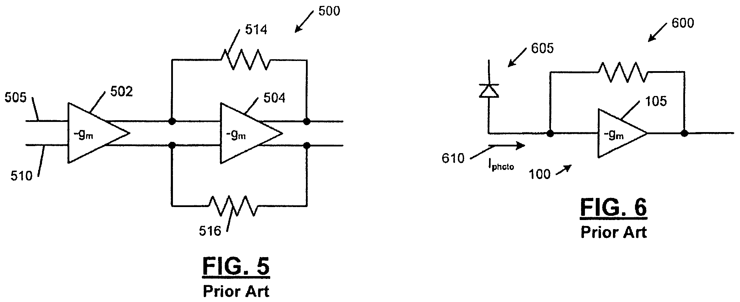

Referring now to FIG. 5, a TIA 500 may be configured to operate differentially using two inputs of each opamp 502 and 504. One input 505 acts as a reference, in a similar manner as ground or virtual ground in a standard configuration TIA. The input voltage Δvᵢ and the output voltage Δvₒ are measured as voltage differences between a reference input 505 and a second input 510. Feedback resistors 514 and 516 are connected across the inputs and the outputs of the opamp 504.

Referring now to FIG. 6, one TIA application having a relatively high bandwidth requirement is that of an optical sensor. An optical sensor circuit 600 includes the opamp 105 and the resistor 110 of the TIA 100 that are coupled with a photodiode 605. The output of the photodiode 605 is a current Iₚₕₒₜₒ 610, which acts as an input to the TIA 100.

The patent publication US6,762,644 B1 discloses an alternative nested TIA.

Increasingly, applications require both high bandwidth and high gain. Examples include optical sensors, such as fiber optic receivers, and preamplifier writers for high-speed hard disk drives.

### SUMMARY OF THE INVENTION

A differential transimpedance amplifier circuit comprises a first operational amplifier having a first inverting input, a first non-inverting input, a first inverting output and a first non-inverting output; a second operational amplifier having a second inverting input, a second non-inverting input, a second inverting output and a second non-inverting output, wherein the second inverting output is connected to the first non-inverting input and the second non-inverting output is connected to the first inverting input; a third operational amplifier having a third inverting input, a third non-inverting input, a third inverting output and a third non-inverting output, wherein the second inverting input is connected to the third non-inverting output and the second non-inverting input is connected to the third inverting output; a fourth operational amplifier having a fourth inverting input, a fourth non-inverting input, a fourth inverting output and a fourth non-inverting output, wherein the fourth inverting output is connected to the third non-inverting input and the fourth non-inverting output is connected to the third inverting input; a first feedback element that is connected to the second non-inverting input and the second inverting output; a second feedback element that is connected to the second inverting input and the second non-inverting output; a third feedback element that is connected to the third non-inverting input and the first inverting output; a fourth feedback element that is connected to the third inverting input and the first non-inverting output; a fifth feedback element that is connected to the fourth inverting input and the first inverting output; and a sixth feedback element that is connected to the fourth non-inverting output and the first non-inverting output.

In other features, the first and second feedback elements comprise first and second resistances, respectively. The third and fourth feedback elements comprise first and second resistances, respectively. The fifth and sixth feedback elements comprise first and second resistances, respectively.

A Sigma-Delta analog to digital converter comprises the differential transimpedance amplifier.

Further areas of applicability of the present invention will become apparent from the detailed description provided hereinafter. It should be understood that the detailed description and specific examples, while indicating the preferred embodiment of the invention, are intended for purposes of illustration only and are not intended to limit the scope of the invention.

### BRIEF DESCRIPTION OF THE DRAWINGS

The present invention will become more fully understood from the detailed description and the accompanying drawings, wherein:
FIGs. 1 and 2 are basic circuit architectures for a current-to-voltage TIA according to the prior art;
FIGs. 3 and 4 are basic circuit architectures for a voltage-to-voltage TIA according to the prior art;
FIG. 5 is a basic circuit architecture for a differential configuration of a TIA according to the prior art;
FIG. 6 shows an optical sensor, including a photodiode coupled to a TIA, according to the prior art;
FIG. 7 is a first-order nested TIA;
FIG. 8 is a second-order nested TIA;
FIG. 9 is an nth-order nested TIA;
FIG. 10 is a first-order nested TIA in a differential configuration;
FIG. 11 is an nth-order nested TIA in a differential configuration;
FIG. 12 is a graph of exemplary gain-bandwidth characteristics for a TIA;
FIG. 13 is a graph of an exemplary gain-bandwidth characteristic for a first-order nested TIA;
FIG. 14 is a graph of an exemplary gain-bandwidth characteristic for a second-order nested TIA;
FIG. 15 is a first-order nested TIA with capacitive cancellation of input parasitic capacitance;
FIG. 16 is a second-order nested TIA with capacitive cancellation of input parasitic capacitance;
FIG. 17 is an nth-order nested TIA with capacitive cancellation of input parasitic capacitance;
FIG. 18 is a first-order nested TIA in a differential configuration with capacitive cancellation of input parasitic capacitance;
FIG. 19 is a second order nested TIA in a differential configuration with capacitive cancellation of input parasitic capacitance;
FIG. 20 illustrates the first order nested TIA of FIG. 7 with additional feedback resistance;
FIG. 21 illustrates a second order nested TIA of FIG. 8 with additional feedback resistance;
FIG. 22 illustrates the first order nested TIA of FIG. 15 with additional feedback resistance;
FIG. 23 illustrates the first order nested TIA of FIG. 7 with an additional input capacitance, feedback capacitance, and feedback resistance;
FIG. 24 illustrates the first order differential mode TIA of FIG. 10 with an additional input capacitance, feedback capacitance, and feedback resistance;
FIG. 25 illustrates an exemplary disk drive system including a preamplifier with a nested TIA;
FIG. 26 illustrates the first order nested TIA of FIG. 7 including an opamp of a first configuration;
FIG. 27 illustrates the differential first-order nested TIA of FIG. 10 including an differential opamp of the first configuration;
FIG. 28 illustrates the first order nested TIA of FIG. 26 including an opamp of a second configuration;
FIG. 29 illustrates the differential first-order nested TIA of FIG. 27 including an differential opamp of the second configuration;
FIG. 30 illustrates the differential first-order nested TIA of FIG. 10 including a differential opamp in a push-pull configuration;
FIGs. 31-33 show a family of gain curves for first and second stages of nested TIAs;
FIG. 34 shows a functional block diagram of a power supply for nested TIAs;
FIG. 35 illustrates and exemplary LED drive circuit using the power supply of FIG. 34;
FIG. 36 is a simplified schematic view of a differential single-nested transimpedance amplifier;
FIG. 37 is a simplified schematic view of a differential double-nested transimpedance amplifier;
FIG. 38 is a simplified schematic view of a differential amplifier nested according to a third embodiment of the disclosure;
FIGs. 39A and 39B are schematic views of differential and single-ended transimpedance amplifiers, respectively, having a compensation capacitor in a feedback loop;
FIGs. 40A and 40B are schematic views of differential and single-ended nested transimpedance amplifiers, respectively, having an LC tank circuit;
FIGs-41A and 41B are schematic views of differential and single-ended transimpedance amplifiers, respectively, having an LC tank circuit and resistors in the feedback loops;
FIG. 42 is a schematic view of an alternative embodiment of a transimpedance amplifier having an LC tank circuit;
FIG. 43A is a functional block diagram of a hard disk drive;
FIG. 43B is a functional block diagram of a digital versatile disk (DVD);
FIG. 43C is a functional block diagram of a high definition television;
FIG. 43D is a functional block diagram of a vehicle control system;
FIG. 43E is a functional block diagram of a cellular phone;
FIG. 43F is a functional block diagram of a set top box;
FIG. 43G is a functional block diagram of a media player; and
FIG. 44 is a functional block diagram of a Delta-Sigma analog to digital converter (ADC).

### DETAILED DESCRIPTION OF THE PREFERRED EMBODIMENTS

The following description of the preferred embodiment(s) is merely exemplary in nature and is in no way intended to limit the invention, its application, or uses.

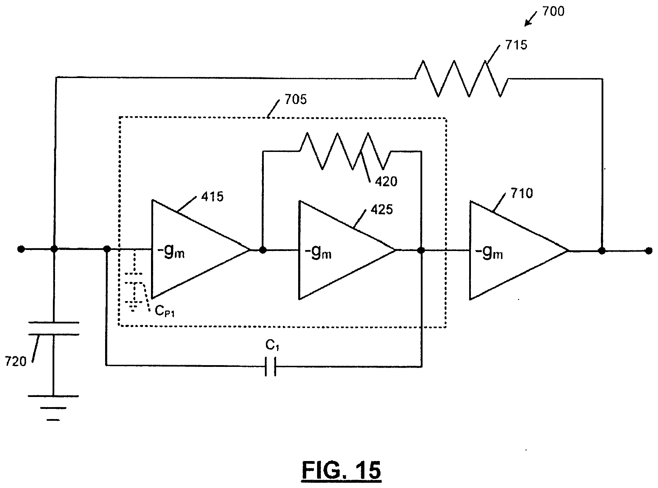

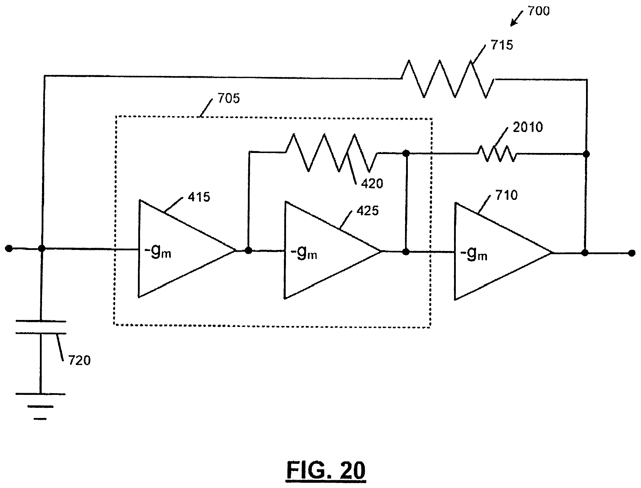

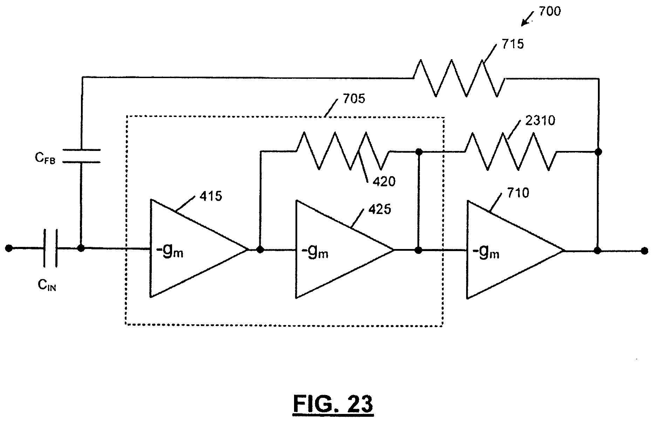

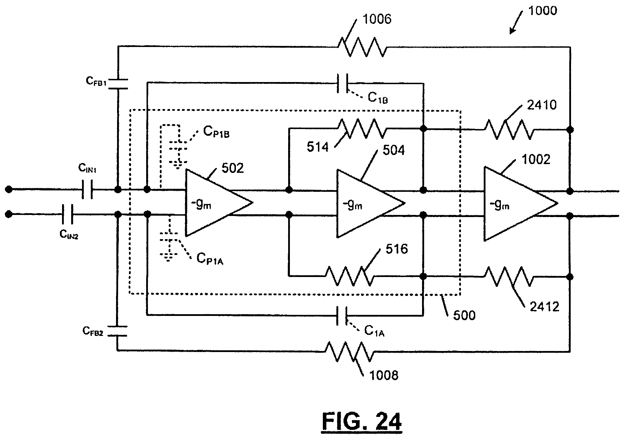

The present invention addresses the need for increasing the gain-bandwidth product of TIAs. Improvements in the gain-bandwidth product are achievable by "nesting" a TIA within another TIA. In other words, additional circuit elements such as feedback resistors, capacitors and/or opamps are added on the input and/or output sides of the TIA. In FIGs. 15-17, capacitive cancellation of the input parasitic capacitance is provided. In FIGs. 20-24, additional feedback resistance is provided. In FIGs. 23 and 24, input and/or feedback capacitance is provided.

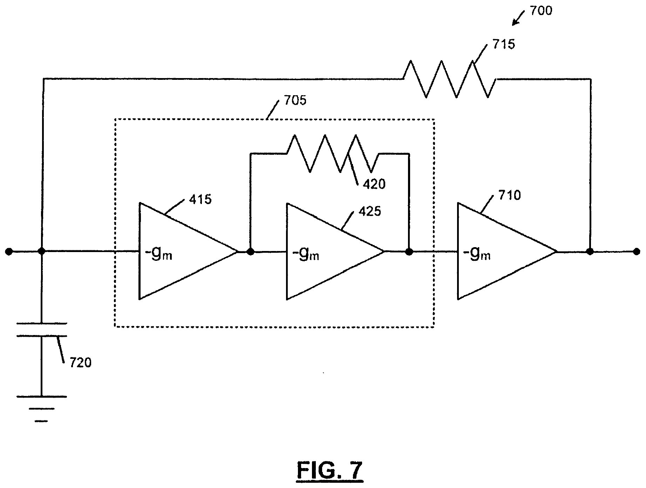

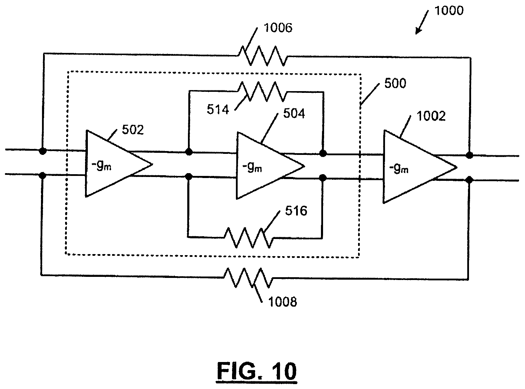

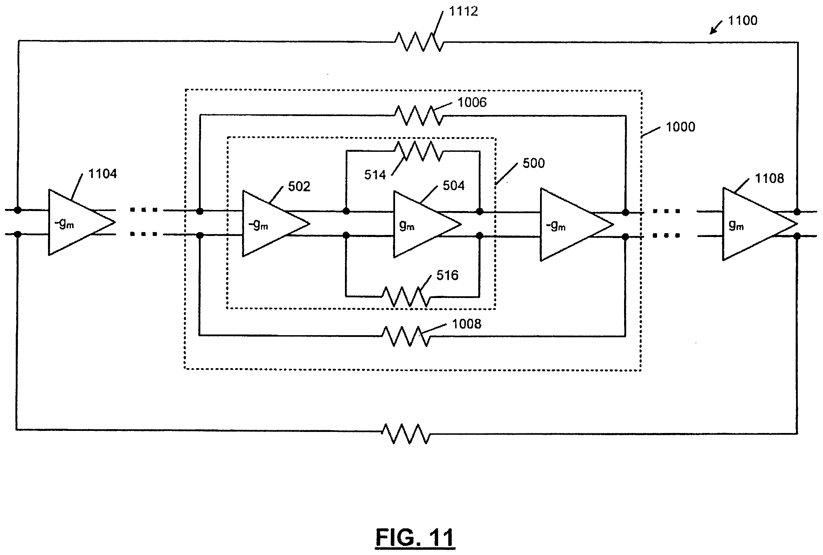

Referring now to FIGs. 7, 8, and 9, a "nested" TIA is constructed by adding opamps, feedback resistors and/or capacitors to a zero-order TIA. In FIGs. 10 and 11, a nested TIA may also be constructed to operate in a differential mode.

Referring back to FIG. 7, a first-order nested TIA 700 is shown. Reference numbers from FIG. 4 are used in FIG. 7 to identify similar elements. The TIA 700 includes a conventional TIA 705 (also referred to herein as a "zero-order" TIA), an opamp 710, and a feedback resistor 715. The feedback resistor 715 may be a standard fixed-value resistor, a nonlinear variable resistor, or an MOS resistor. A capacitor 720 is also connected between an input of the TIA 700 and ground (or virtual ground).

By nesting the TIA in this manner, improvements in the gain-bandwidth product may be realized. For example, the first-order nested TIA 700 that uses MOS transistors may achieve a bandwidth that is 10% - 20% of the threshold frequency f_{T}. This range represents a bandwidth that is approximately five to ten times greater than the bandwidth of the corresponding zero-order TIA.

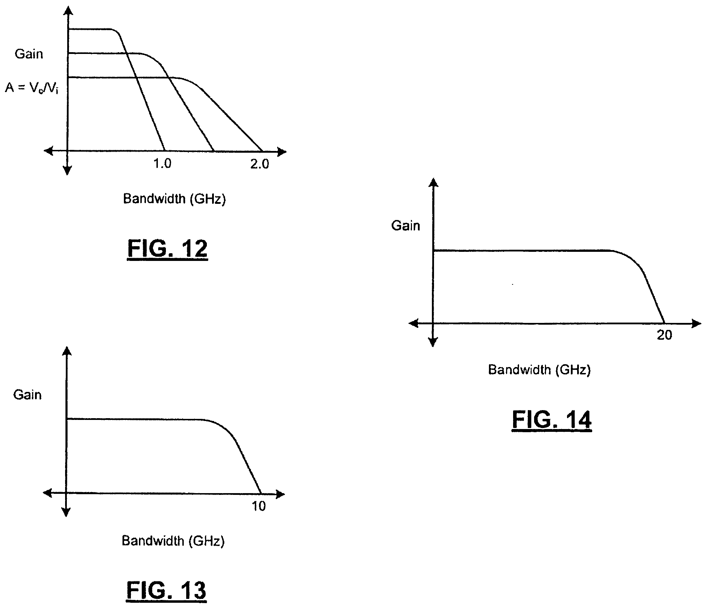

Referring now to FIGs. 12 and 13, graphs illustrating characteristic gain-bandwidth curves for a zero-order TIA and a first-order nested TIA, respectively, are shown. In general, a higher value of gain is associated with a lower value of bandwidth, and a lower value of gain is associated with a higher value of bandwidth. The gain A, defined as the output voltage Δvₒ divided by the input voltage Δvᵢ, is typically on the order of a few hundred or a few thousand (i.e., approximately 10² - 10³). A typical range of threshold frequency (f_{T}) values for a 0.13 µm CMOS process is 30 GHz - 40 GHz.

In FIG. 12, three exemplary characteristic curves are shown. A high gain value yields a bandwidth value of approximately 1 GHz. A medium gain value increases the bandwidth to approximately 2 GHz. Other values of gain and bandwidth are possible. For example, a TIA may have a characteristic gain value that is higher than the maximum shown in FIG. 12 and a bandwidth that is less than 1 GHz. A TIA may have a characteristic gain value that is lower than the minimum gain value shown in FIG. 12 and a bandwidth that is greater than 2 GHz. As can be appreciated, the bandwidth varies as an inverse function of gain. This function may be referred to as the "spread". The spread is greater for TIAs using MOS transistors than for TIAs using bipolar junction transistors (BJTs). Thus, the need to improve the TIA bandwidth performance is more pronounced with MOS transistors than with BJT transistors.

The exemplary bandwidth values shown in FIG. 12 do not define upper and lower bandwidth bounds. In many practical applications, bandwidths on the order of 1 GHz or 2 GHz are too low. Many applications, such as an OC192 fiber optic receiver, require bandwidths on the order of 10 GHz. Preamplifiers for high-speed hard disk drives also typically require bandwidths that are on the order of several GHz. Referring now to FIG. 13, a first-order nested TIA at a typical gain value may have a bandwidth of approximately 10 GHz.

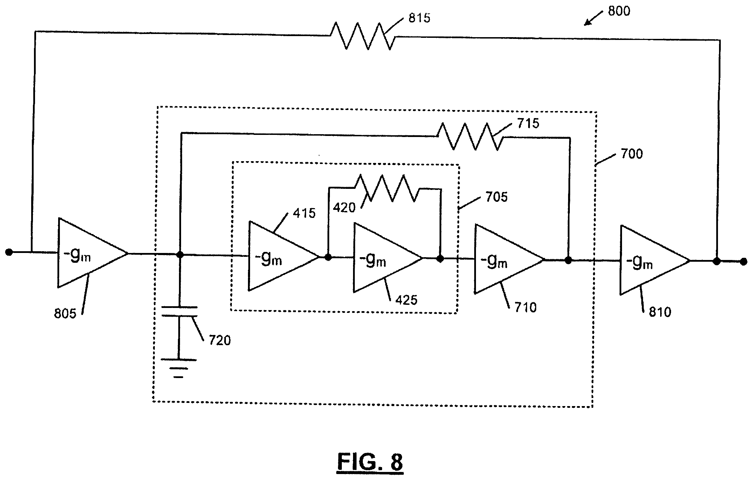

Referring now to FIG. 8, a second-order nested TIA 800 builds upon the first-order nested TIA 700. Reference numbers from FIGs. 4 and 7 are used in FIG. 8 to identify similar elements. The second-order nested TIA 800 includes an opamp 805 at the input of the first-order nested TIA 700 and an opamp 810 at the output of the first-order nested TIA 700. An additional feedback resistor 815 is also added across the input of the opamp 805 and the output of the opamp 810. An exemplary gain-bandwidth curve that is produced using the second-order nested TIA 800 is shown in FIG. 14. For a typical gain value, a bandwidth of approximately 20 GHz may be achieved.

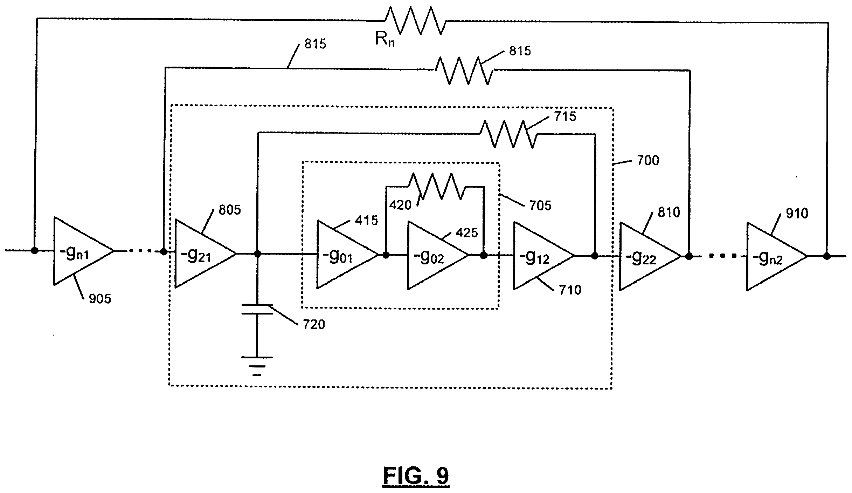

Referring now to FIG. 9, higher-order nested TIAs may be constructed by adding additional opamps and feedback resistors. Reference numbers from FIGs. 4, 7 and 8 are used in FIG. 9 to identify similar elements. For example, a third-order nested TIA 900 includes opamps 905 and 910 and feedback resistor 915. It is possible to achieve higher values of either gain or bandwidth (or both) by repeating the technique of the present invention. However, the efficiency of the circuit decreases as additional nesting levels are added due to parasitic noise and increased power dissipation. In general, either the first-order nested TIA or the second-order nested TIA will usually provide sufficient performance.

Referring now to FIG. 10, a differential mode first-order nested TIA 1000 is shown. Reference numbers from FIG. 5 are used in FIG. 10 to identify similar elements. An opamp 1002 is connected to the outputs of the opamp 504. Feedback resistors 1006 and 1008 are connected to inputs of the differential mode TIA 500 and to outputs of the opamp 1002. The gain-bandwidth product of the TIA is increased.

Referring now to FIG. 11, a differential mode nth-order nested TIA 1100 is constructed in a manner that is similar to the nth-order nested TIA of FIG. 9. Reference numbers from FIGs. 5 and 10 are used in FIG. 11 to identify similar elements. Additional opamps 1104 and 1108 and feedback resistors 1112 and 1114 are connected in a similar manner. The gain-bandwidth characteristics for differential mode TIAs are substantially similar to the gain-bandwidth characteristics shown in FIGs. 12-14.

It is noted that the opamps used in the nested TIA may employ either bipolar junction transistors (BJTs), such as gallium-arsenide (GaAs) transistors, or metal-oxide-semiconductor (MOS) transistors, such as CMOS or BICMOS transistors. The preferred embodiments of the invention use MOS transistors due to practical considerations such as ease of manufacture and better power consumption characteristics.

Referring now to FIG. 15, the first order nested TIA 700 is shown with additional feedback capacitance C₁, which substantially cancels effects of an input capacitance C_{P1} at the input of the opamp 415. The feedback capacitance C₁ has a first end that communicates with an input of the opamp 415 and a second end that communicates with an output of the opamp 425.

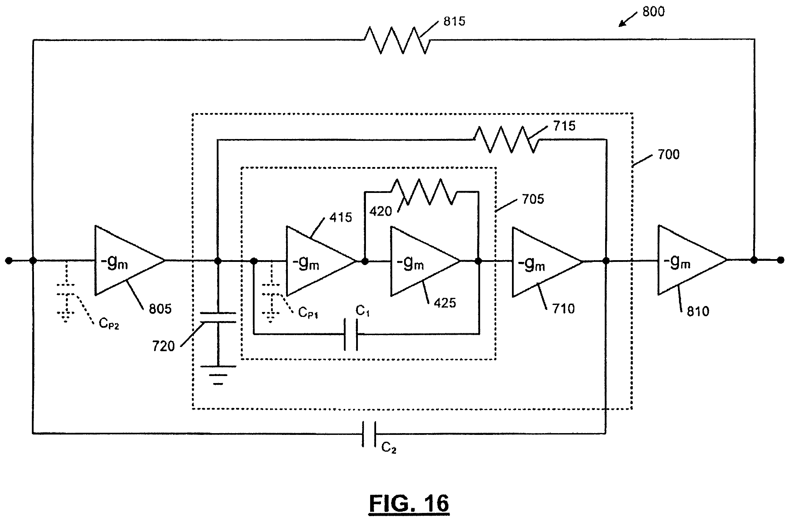

Referring now to FIG. 16, the second order nested TIA 800 of FIG. 8 is shown with additional feedback capacitances C₁ and C₂, which substantially cancel effects of input capacitances C_{P1} and C_{P2} at the inputs of opamps 415 and 805, respectively. The feedback capacitance C₁ has a first end that communicates with an input of the opamp 415 and a second end that communicates with an output of the opamp 425. The feedback capacitance C₂ has a first end that communicates with an input of the opamp 805 and a second end that communicates with an output of the opamp 710.

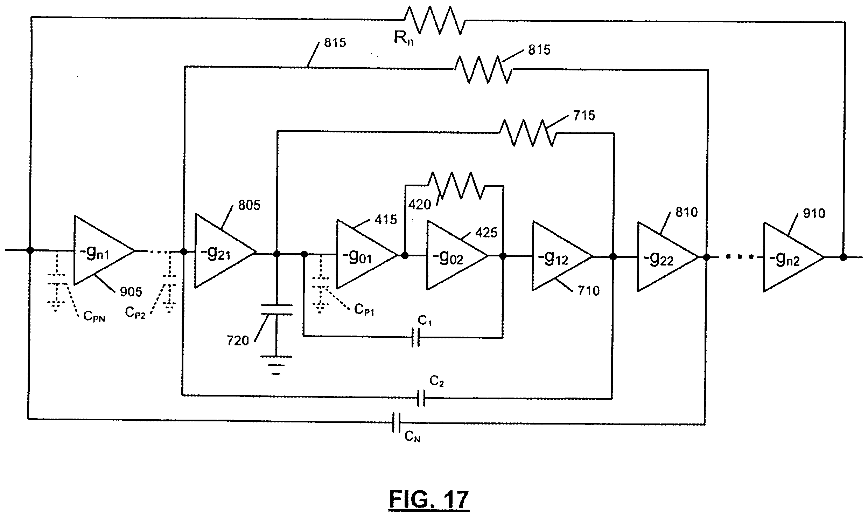

Referring now to FIG. 17, the nth order nested TIA of FIG. 9 is shown with additional feedback capacitances C₁, C₂, ..., and C_{N}, which substantially cancel effects of input capacitances C_{P1}, C_{P2}, ..., and C_{PN} at the inputs of opamps 415, 805 and 905, respectively. The feedback capacitance C₁ has a first end that communicates with an input of the opamp 415 and a second end that communicates with an output of the opamp 425. The feedback capacitance C₂ has a first end that communicates with an input of the opamp 805 and a second end that communicates with an output of the opamp 710. The feedback capacitance C_{N} has a first end that communicates with an input of the opamp 905 and a second end that communicates with an output of the opamp 810.

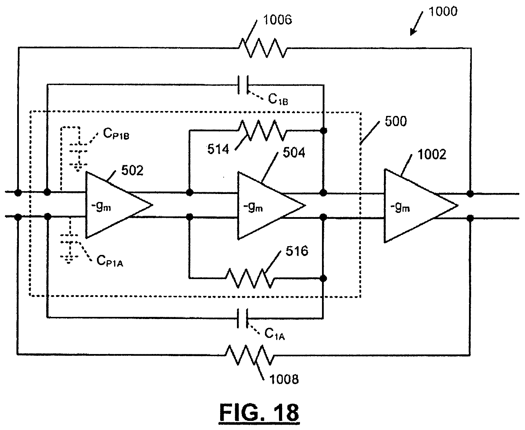

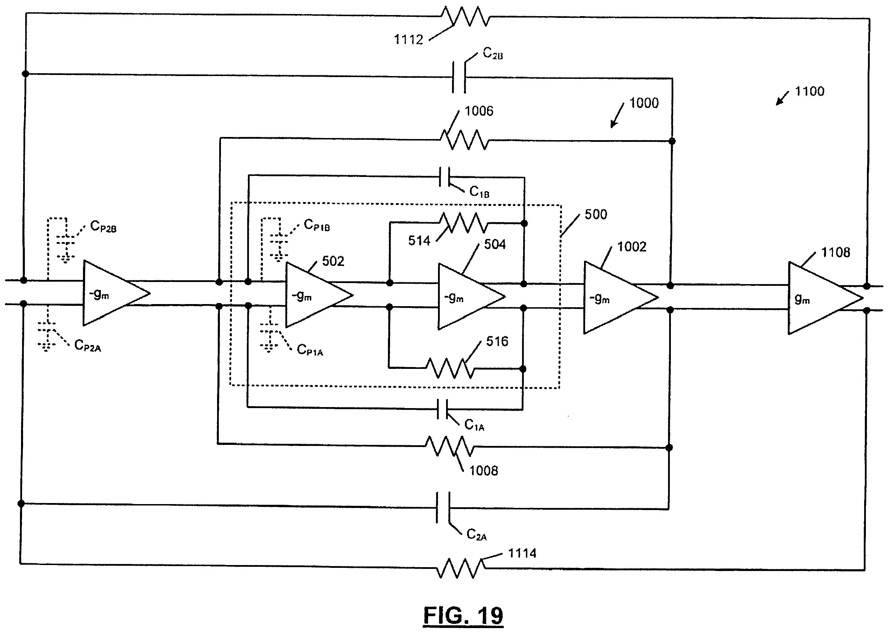

Referring now to FIG. 18, the first order nested differential mode TIA 1000 is shown with additional feedback capacitors C_{1A} and C_{1B}, which substantially cancel effects of input parasitic capacitances C_{P1} and C_{P2} at the inputs of the differential mode opamp 502. The feedback capacitance C_{1A} has a first end that communicates with an input of the differential mode opamp 502 and a second end that communicates with an output of the differential mode opamp 504. In FIG. 19, additional capacitances C_{2A} and C_{2B} are added to a second order differential mode TIAs in a similar manner to offset parasitic capacitances C_{P2A} and C_{P2B}. Higher order circuits Use a similar approach.

Referring back to FIG. 20, the first order nested TIA of FIG. 7 is shown with additional feedback resistance 2010. The feedback resistance 2010 has a first end that communicates with an input of the opamp 710. A second end of the resistance 2010 communicates with an output of the opamp 710.

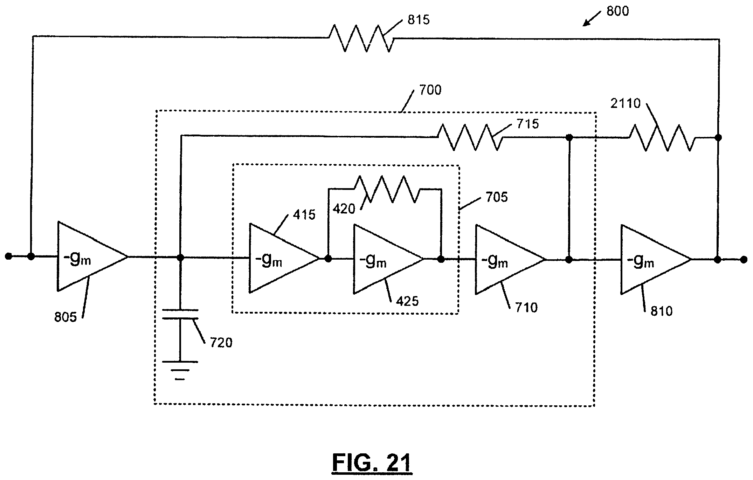

Referring now to FIG. 21, the second order nested TIA of FIG. 8 is shown with additional feedback resistance 2110. The feedback resistance 2110 has a first end that communicates with an input of the opamp 810. A second end of the resistance 2110 communicates with an output of the opamp 810.

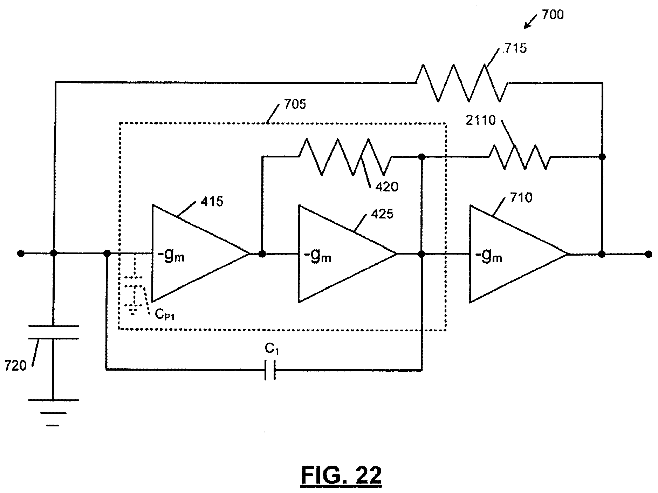

Referring now to FIG. 22, the first order nested TIA of FIG. 15 is shown with additional feedback resistance 2210. The feedback resistance 2210 has a first end that communicates with an input of the opamp 710. A second end of the resistance 2210 communicates with an output of the opamp 710.

Referring now to FIG. 23, the first order nested TIA of FIG. 7 is shown with input capacitance C_{IN}, feedback capacitance C_{FB}, and feedback resistance 2310. The input capacitance C_{IN} has a first end that receives an input signal for the nested TIA 700 and a second end that communicates with an input of opamp 415. The feedback capacitance C_{FB} has a first end that communicates with an input of opamp 415 and a second end that communicates with one end of resistance 715.

The additional feedback resistances, input capacitances, and/or feedback capacitances can also be added to the differential mode nested TIA. Referring now to FIG. 24, the first order differential mode nested TIA of FIG. 10 is shown with first and second input capacitances C_{IN1} and C_{IN2}, first and second feedback capacitances C_{FB1} and C_{FB2}, and feedback resistances 2410 and 2412. The input capacitances C_{IN1} and C_{IN2} have first ends that receive input signals for the nested differential mode TIA and second ends that communicate with inputs of opamp 502. The feedback capacitances C_{FB1} and C_{FB2} have first ends that communicate with inputs of opamp 502 and second ends that communicate with first ends of resistances 1006 and 1008, respectively. First and second feedback resistances 2410 and 2412 have first ends that are connected to inputs and second ends that are connected to outputs of differential mode opamp 1002.

As can be appreciated, the feedback capacitances (FIG.s 15-19), feedback resistances (FIGs. 20-24), and input and feedback capacitances (FIGs. 23 and 24) can be used in any combination on first, second, ... or n^{th} order nested TIA and/or differential mode TIA.

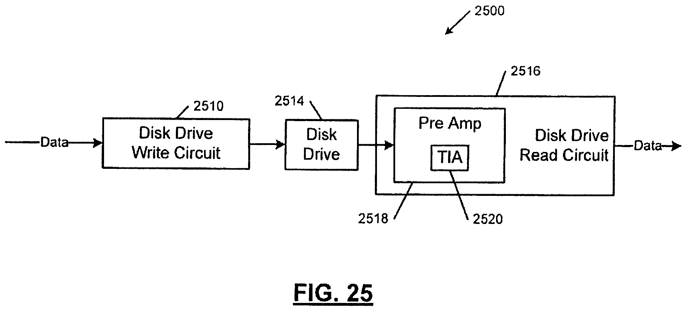

Referring now to FIG. 25, an exemplary disk drive system 2500 is shown to include a disk drive write circuit 2510 that writes to a disk drive 2514. A disk drive read circuit 2516 includes a preamp circuit 2518 with a nested TIA or nested differential mode TIA identified at 2520, which is implemented as described above.

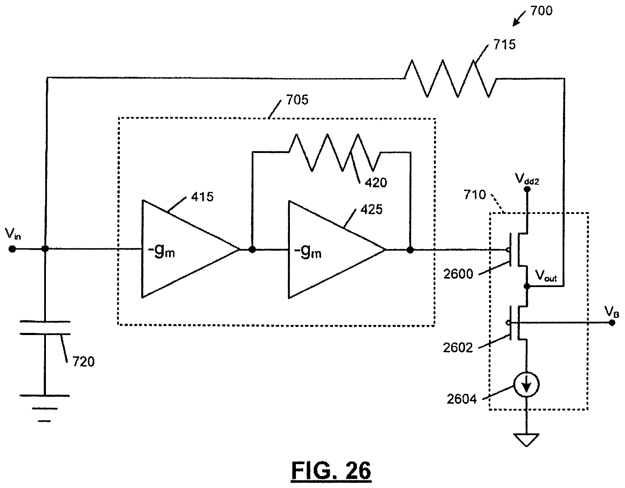

Referring now to FIG. 26, the first-order nested TIA 700 of FIG. 7 is shown including a first implementation of opamp 710. Opamp 710 includes a first transistor 2600 in series with a second transistor 2602. A gate of the first transistor 2600 is driven by the output of the zero-order TIA 705. A gate of the second transistor 2602 is driven by a bias voltage V_{B}. The signal output of TIA 700 is taken at a node connecting a source of the first transistor 2600 with a drain of the second transistor 2602. A first current source 2604 draws current from a source of the second transistor 2602. The opamp 710 can be powered with a drain supply voltage V_{dd2}. Power supply options are described below in more detail.

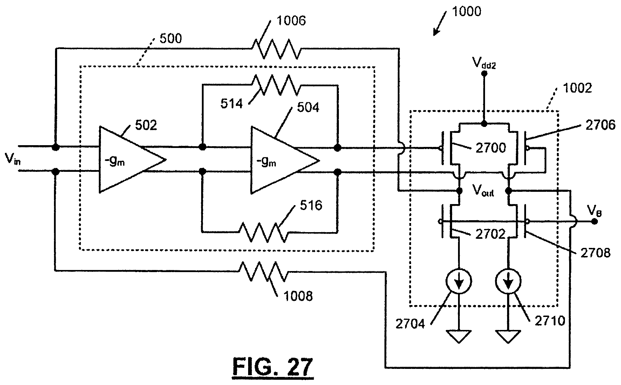

Referring now to FIG. 27, the differential mode first-order nested TIA 1000 of FIG. 10 is shown including a first implementation of opamp 1002. Opamp 1002 includes a first transistor 2700 in communication with a second transistor 2702. A gate of the first transistor 2700 is driven by one output of the differential zero-order TIA 500. A gate of the second transistor 2702 is driven by a bias voltage V_{B}. A first signal output of TIA 1000 is taken at a node connecting a source of the first transistor 2600 with a drain of the second transistor 2702. A first current source 2704 draws current from a source of the second transistor 2702.

A third transistor 2706 is in communication with a fourth transistor 2708. A gate of the third transistor 2706 is driven by the other output of the differential zero-order TIA 500. A gate of the fourth transistor 2708 is driven by V_{B}. A second signal output of TIA 1000 is taken at a node connecting a source of the third transistor 2706 with a drain of the fourth transistor 2708. A second current source 2710 draws current from a source of the second transistor 2702. The opamp 1002 can be powered with a drain supply voltage V_{dd2}. Power supply options are described below in more detail. The differential signal output is taken across the first and second signal outputs at the respective sources of first and third transistors 2700, 2706.

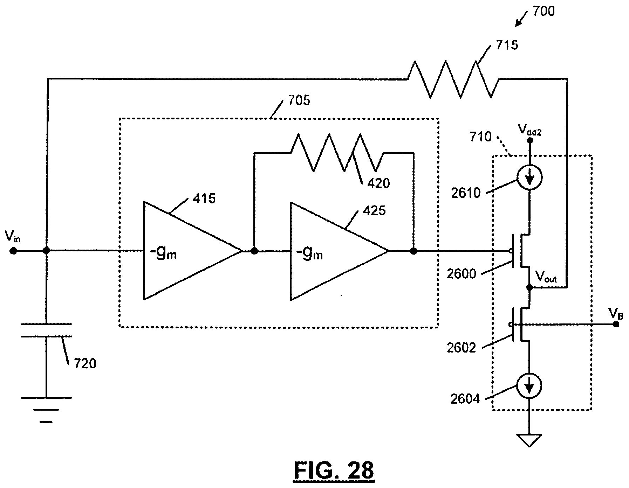

Referring now to FIG. 28, the first-order nested TIA 700 of FIG. 26 is shown including a second implementation of opamp 710. The second implementation includes a second current source 2610 that provides current to the drain of the first transistor 2600. The second current source 2610 draws current from V_{dd2}.

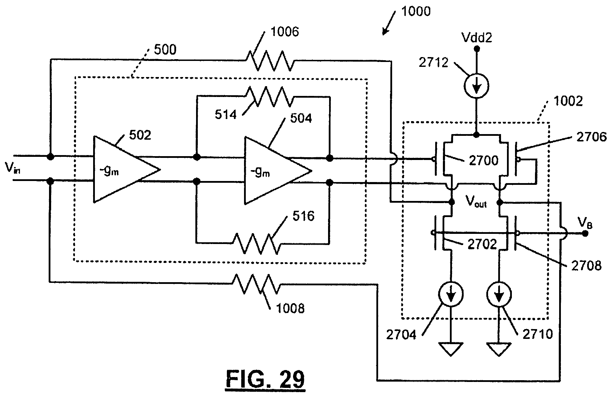

Referring now to FIG. 29, the differential mode first-order nested TIA 1000 of FIG. 27 is shown including a second implementation of opamp 1002. The second implementation includes a third current source 2712 that provides current to the drains of first transistor 2700 and third transistor 2706. The third current source 2712 draws current from V_{dd2}.

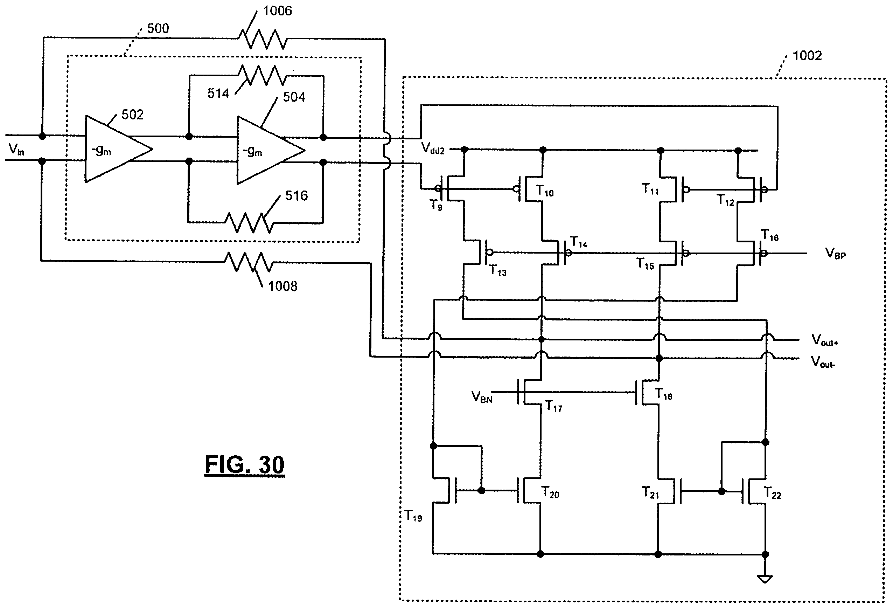

Referring now to FIG. 30, the differential mode first-order nested TIA 1000 of FIG. 10 is shown including a third implementation of opamp 1002. Opamp 1002 includes a push-pull configuration as shown. The opamp 1002 receives a positive bias voltage V_{BP} and a negative bias voltage V_{BN}. The differential output signal is taken across nodes Vₒᵤₜ₊ and Vₒᵤₜ₋.

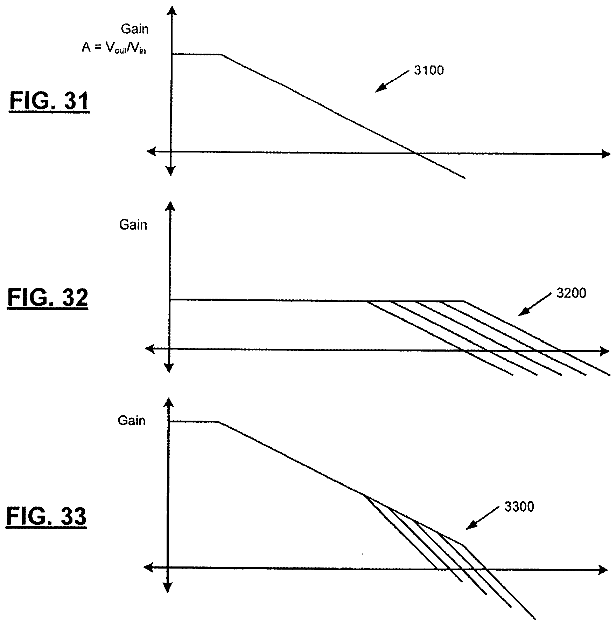

Referring now to FIGS. 31-33, a family of gain curves is shown. The gain curves represent typical gain patterns of the various first-order nested TIAs described above. A logarithmic vertical axis of each graph represents gain A=Vₒᵤₜ*N*ᵢₙ. A logarithmic horizontal axis of each graph represents signal frequency. The graph of FIG. 31 represents a gain curve 3100 of the various opamps. The opamps provide a lower gain and higher bandwidth than the zero-order TIAs. The opamp gain rolls off at a rate of 20dB/decade.

The graph of FIG. 32 represents a family of gain curves 3200 for various TIAs. The gain curve 3200 having the smallest bandwidth corresponds with a zero-order TIA. The gain curves 3200 with higher bandwidths correspond with increasingly-nested TIAs. The TIAs generally provide a high gain and medium bandwidth when compared to the opamps. The zero-order TIA gain rolls off at a rate of 20dB/decade.

The graph of FIG. 33 represents a family of gain curves 3300 of the various first-order nested TIAs. The gains are relatively flat at the lowest frequencies. As the frequency increases the gains roll off at 20dB/decade due to the gain effects of the opamp as shown in FIG. 31. As the frequency continues to increase the gains roll off at 40dB/decade due to the combined effects of the opamp and the selected zero-order TIA.

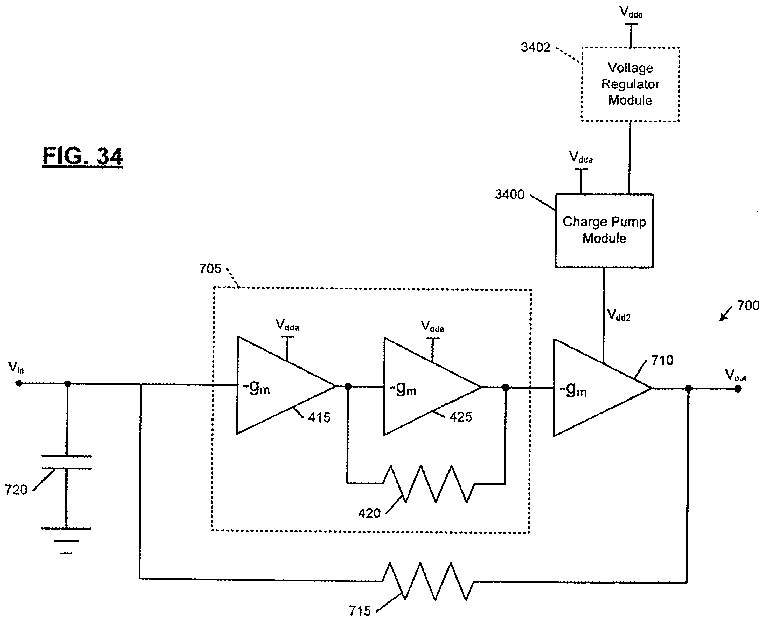

Referring now to FIG. 34, a functional block diagram is shown of a power supply arrangement for first-order nested TIAs. The power supply arrangement provides a TIA chip with three unique voltages levels despite providing external connections for two voltages and ground. While FIG. 34 shows the power supply connected to the first-order nested TIA 700 of FIG. 7, it is understood by those skilled in the art that the power supply may be used with other single-ended and differential first-order nested TIAs. An analog power supply V_{dda} is associated with one of the external connections and provides power to the zero-order TIA. In some examples V_{dda} is between about 2.5V and 3.3V.

The analog power supply V_{dda} also provides power to a charge pump module 3400. Charge pump module 3400 also receives power from a digital power supply V_{ddd}. V_{ddd} is associated with the second one of the external connections. Charge pump module 3400 can be fabricated on the same chip as the first-order nested TIAs. In some examples V_{ddd} is about 1.2V. In some embodiments V_{ddd} can be regulated by a voltage regulator module 3402 before being applied to the charge pump module 3400. The charge pump module 3400 generates a second digital voltage V_{dd2} that is approximately equal to V_{dda}+V_{ddd}. Therefore V_{dd2}>V_{dda}. It is appreciated by those skilled in the art that V_{dd2} is not exactly equal to V_{dda}+V_{ddd} due to losses and/or inefficiencies inherent in the charge pump module 3400.

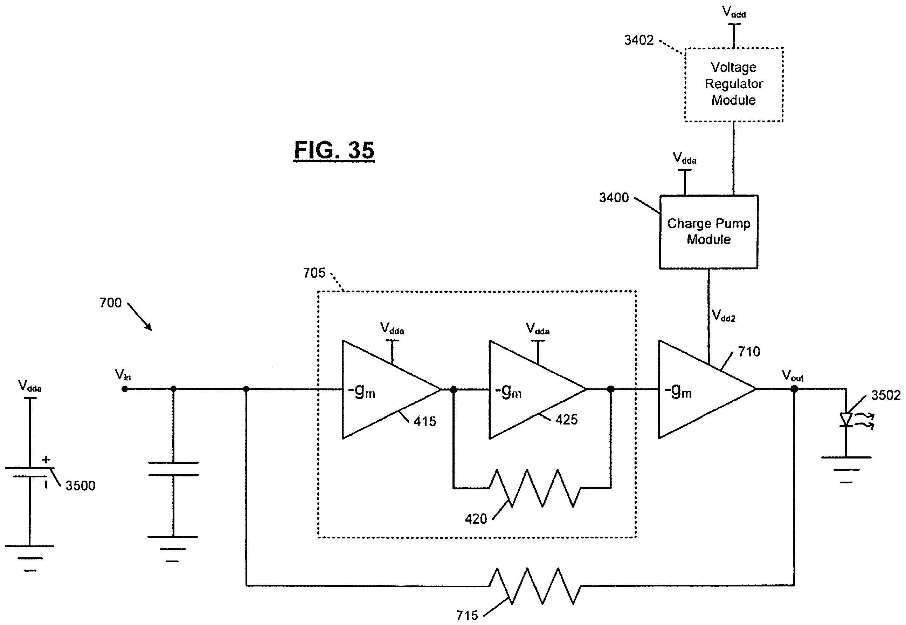

Referring now to FIG. 35, an application of the power supply of FIG. 35 is shown. V_{dda} is provided by a battery 3500. Battery 3500 can be a lithium-ion battery having a voltage between about 2.7V and 4.2V. A light-emitting diode (LED) communicates with an output of the opamp 710. In some embodiments the LED has a turn-on voltage V_{D} of about 3.5V. The charge pump module 3400 adds V_{dda} from the battery 3500 to V_{ddd} to generate sufficient voltage for driving the LED 3502. Since V_{ddd} generally provides only about 1.2V it can not be used alone to power the LED 3502. The charge pump module 3400 provides the additional voltage from V_{dda} to supply the LED with approximately 3.7V to 4.2V, which is above the 3.5V V_{D}. The range of 3.7V to 4.2V accounts for the losses and/or inefficiencies in the charge pump module 3400 and is therefore not exactly equal to V_{dda}+V_{ddd}.

The present disclosure also addresses the need for increasing the gain-bandwidth product of TIAs. Improvements in the gain-bandwidth product may be achievable by "nesting" a TIA within another TIA. In other words, additional circuit elements such as feedback resistances, capacitances and/or opamps are added on the input and/or output sides of the TIA.

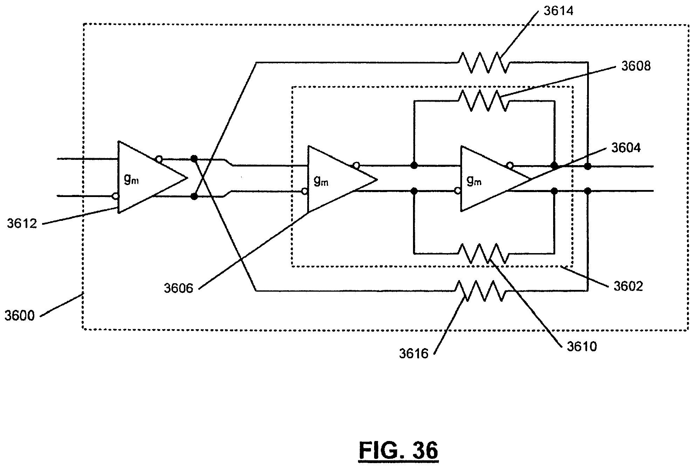

Referring now to Figure 36, a nested transimpedance amplifier (TIA) circuit 3600 having an inner TIA 3602 is illustrated. The transimpedance amplifier 3602 includes a first operational amplifier 3604 and a second operational amplifier 3606. Each operational amplifier set forth in this figure and the following figures has a non-inverting input and non-inverting output identified by the absence of the "o" symbol, and an inverting input and inverting output identified by the "o" symbol. The transimpedance amplifier 3602 also includes a first feedback resistance 3608 that communicates with the non-inverting input and the inverting output, and a second resistance 3610 that communicates with the inverting input and the non-inverting output.

The nested transimpedance amplifier 3600 also includes a third operational amplifier 3612 also having an inverting input and output, and a non-inverting input and output. The operational amplifier 3612 has an inverting output that communicates with the non-inverting input of amplifier 3606, and a non-inverting output that communicates with the inverting input of amplifier 3606.

A feedback resistance 3614 communicates with the non-inverting output of amplifier 3612 and the inverting output of amplifier 3604. The inverting output of amplifier 3612 communicates with the non-inverting output of amplifier 3604. That is, resistance 3614 communicates with the inverting input of amplifier 3606, while resistance 3616 communicates with the non-inverting input of amplifier 3606.

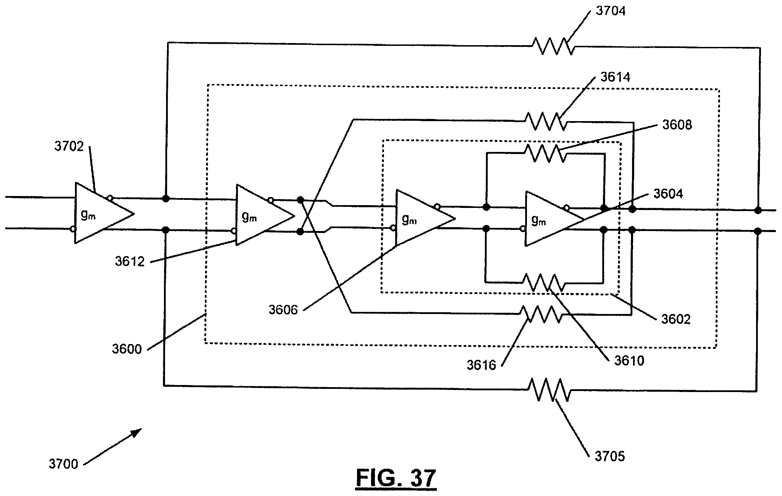

Referring now to FIG. 37, a double-nested transimpedance amplifier 3700 is illustrated. The double-nested transimpedance amplifier includes the transimpedance amplifier 3602 and the nested transimpedance amplifier structure 3600 of FIG. 36. Therefore, these common circuit components will not be described further. In this example, another amplifier 3702 also having inverting and non-inverting inputs and outputs is illustrated. In this embodiment, the inverting output of amplifier 3702 communicates with the non-inverting input of amplifier 3612. The non-inverting output of amplifier 3702 communicates with the inverting input of amplifier 3612. A feedback resistance 3704 communicates with the common node of the inverting output of amplifier 3702 and the non-inverting input of amplifier 3612. The resistance 3704 is also communicates with the inverting output of amplifier 3604. A second feedback resistance 3705 communicates with the common node between the non-inverting output of amplifier 3702 and the inverting input of amplifier 3612, and the non-inverting output of amplifier 3604.

By providing the differentials and feedback structures illustrated in FIGs. 36 and 37, fewer inversions for a given level of nesting are set forth. The result is a potentially higher frequency operation from a device such as that illustrated in FIG. 7. In these examples, the nesting occurs at the output node causing the output distortion to be improved as the level of nesting increases.

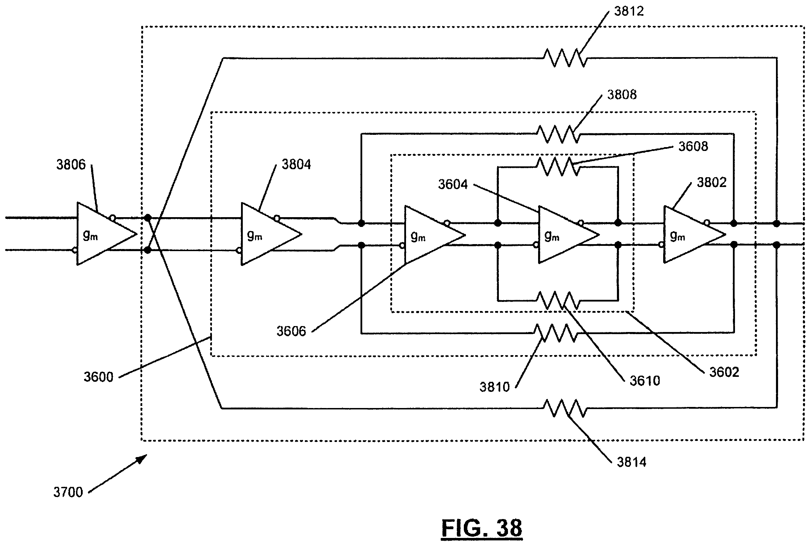

Referring now to FIG. 38, a transimpedance structure 3602 illustrated in FIG. 36 is used in a nested TIA 3800. In this embodiment, an operational amplifier 3802 has its inverting input connected to the non-inverting output of amplifier 3604. The non-inverting input of amplifier 3802 is connected to the inverting output of amplifier 3604.

Another amplifier 3804 has an inverting output that is connected to the non-inverting input of amplifier 3606. The non-inverting output of amplifier 3804 connected to the inverting input of amplifier 3606. Another operational amplifier 3806 has an inverting output that is connected to the non-inverting input of amplifier 3804 and a non-inverting output that is connected to the inverting input of amplifier 3804. A first feedback resistance 3808 is connected to the common node between the inverting output of amplifier 3804 and the non-inverting input of amplifier 3606, and the inverting output of amplifier 3802. Another feedback resistance 3810 is connected to the common node of the non-inverting output of amplifier 3804 and the inverting input of amplifier 3606, and the non-inverting output of amplifier 3802.

A feedback resistance 3812 is connected to the common node between the non-inverting output of amplifier 3806 and the inverting amplifier 3804, and the inverting output of amplifier 3802. Another resistance 3814 is connected to the node between inverting output of amplifier 3806 and the non-inverting input of amplifier 3804, and the non-inverting output of 3802.

Different types of nesting may be performed to build a higher order nested transimpedance amplifier. The amplifier 3802 is not important as far as nesting is concerned. If the input of the circuit is current instead of voltage, amplifier 3806 may not be required.

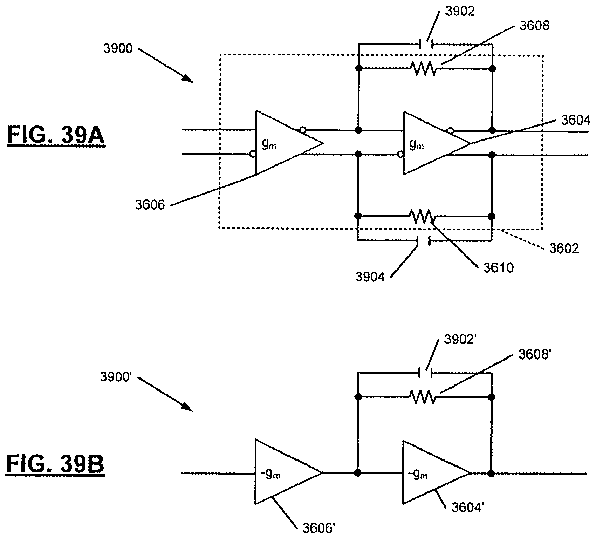

Referring now to FIGs. 39A and 39B, differential and single-ended transimpedance amplifiers having capacitive feedback are shown, respectively. In FIG. 39A, a differential transimpedance amplifier 3900, which is similar to the transimpedance amplifier 3602 of FIG. 36, is illustrated having a first capacitance 3902 in parallel with resistance 3608 and a second capacitance 3904 in parallel with resistance 3610. In this example, the frequency response or the stability of the transimpedance network may be improved by including the capacitances 3902 and 3904. As can be appreciated, the capacitances can be replaced by inductances if desired.

In FIG. 39B, a single-ended transimpedance amplifier 3900' is shown that is similar to the differential configuration shown in FIG. 39A. In FIG. 39B, similar elements are labeled with a prime symbol "'". The transconductance gₘ of the amplifiers 3604' and/or 3606' may be negative and/or the signals may be coupled to inverting input(s) of the amplifiers 3604' and/or 3606'.

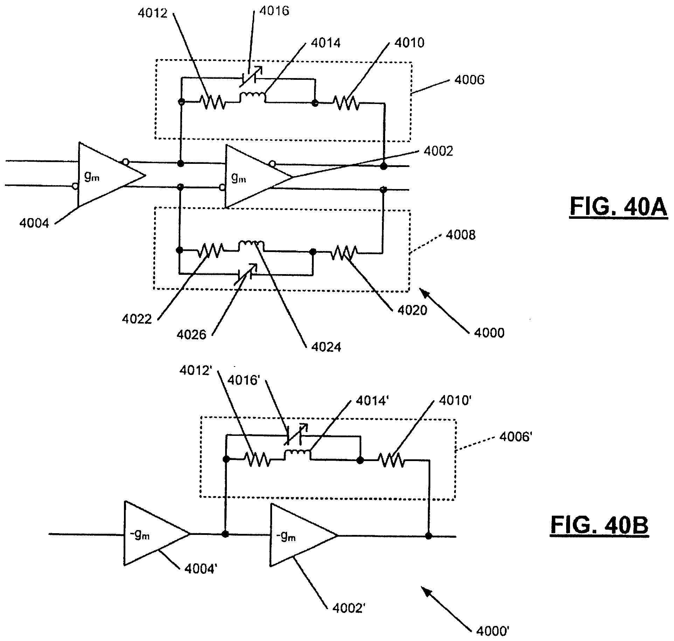

Referring now to FIGs. 40A and 40B, an LC tank circuit is included in the feedback of differential and single-ended transimpedance amplifiers, respectively. In FIG. 40A, a differential transimpedance amplifier 4000 is shown. In this example, a first operational amplifier 4002 has a non-inverting input communicates with an inverting output of amplifier 4004. The inverting input of amplifier 4002 communicates with the non-inverting output of amplifier 4004. A feedback element 4006 communicates with the common node of the non-inverting input of amplifier 4002 and the inverting output of amplifier 4004, and the inverting output of amplifier 4002. Likewise, a second feedback element 4008 communicates with the common node of the inverting input of amplifier 4002 and the non-inverting output of amplifier 4004, and the non-inverting output of amplifier 4002.

The feedback element 4006 includes a resistance 4010, a series combination of a resistance 4012, and an inductance 4014. In some implementations, the inductance 4014 can be a variable inductance. A variable capacitance 4016 is coupled in parallel with the series combination of the resistance 4012 and the inductance 4014. This parallel combination is coupled in series with the resistance 4010. Likewise, the feedback element 4008 is configured in a similar way with a resistance 4020, a second resistance 4022 in series with an inductance 4024, and a variable capacitance 4026.

The variable capacitances 4016 and 4026 are used to illustrate that various resonant frequencies of the LC tank circuit may be adjusted by changing the capacitance values. In an actual example, a fixed capacitance set to the desired residence frequency may be used. The circuit 4000 may be suitable for use as an RF amplifier in a TV tuner in which it is desirable to include an ultra-wide band of operation (e.g., 50 MHz-1 GHz). The circuit amplifies the wanted signal more than the unwanted signal by taking advantage of the LC tank in combination with the transimpedance amplifier property of the wide-band operation. The parallel LC tank circuit causes the feedback network to have high impedance at a resonance frequency of the LC tank circuit.

The structure illustrated in FIG. 40 may also be nested in an amplifier structure illustrated above. With each subsequent nesting, only the signal frequency of interest is amplified so that the nesting behavior is effective at the residence frequency of the LC tank elements. Because of this, the selectivity of the nested LC tank circuit transimpedance amplifier is significantly improved while the out-of-band signals are not amplified. This improves the distortion performance of the amplifier by not amplifying the unwanted signals. At the same time, in-band signals are amplified with extremely low distortion because of the nature of the nesting transimpedance amplifier.

In FIG. 40B, a single-ended transimpedance amplifier 4000' is shown that is similar to the differential configuration shown in FIG. 40A. In FIG. 40B, similar elements are labeled with a prime symbol "'". The transconductance gₘ of the amplifiers 4002' and/or 4004' may be negative and/or the signals may be coupled to inverting input(s) of the amplifiers 4002' and/or 4004'.

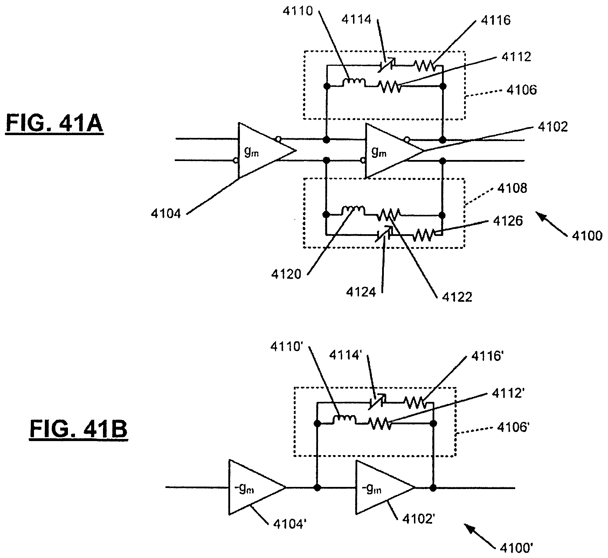

Referring now to FIGs. 41A and 41B, a schematic view of another embodiment of differential and single-ended transimpedance amplifiers are shown, respectively. In FIG. 41A, a differential transimpedance amplifier 4100 using an LC circuit is illustrated. In this example, a first operational amplifier 4102 communicates with a second amplifier 4104. An inverting output of amplifier 4104 communicates with a non-inverting input of amplifier 4102. A non-inverting output of amplifier 4104 communicates with an inverting input of amplifier 4102. A first LC circuit 4106 communicates with the non-inverting input of amplifier 4102 and the inverting output of amplifier 4102. A second LC circuit 4108 communicates with the inverting input and the non-inverting output of amplifier 4102.

LC circuit 4106 includes an inductance 4110 in series with a resistance 4112. The LC circuit 4106 also includes a capacitance 4114 in series with a resistance 4116. The series combination of the capacitance 4114 and resistance 4116 is in parallel with the series combination of the inductance 4110 and the resistance 4112.

The LC circuit 4108 is configured in a similar manner to LC circuit 4106. The LC circuit 4108 includes an inductance 4120 in series with a resistance 4122. A capacitance 4124 is in series with a resistance 4126. The series combination of the inductance 4120 and resistance 4122 is in parallel with the series combination of the capacitance 4124 and the resistance 4126.

By providing a resistance in parallel with the LC tank circuit, as illustrated in FIG. 40, or adding a resistance to both the inductance and capacitance, oscillations of the circuit are avoided. The extra resistance, as compared to FIG. 40, prevents the polarity of the amplifier from changing at high frequencies. This is used to prevent feedback operation within the nested transimpedance structure.

In FIG. 41B, a single-ended transimpedance amplifier 4100' is shown that is similar to the differential configuration shown in FIG. 41A. In FIG. 41B, similar elements are labeled with a prime symbol "'". The transconductance gₘ of the amplifiers 4102' and/or 4104' may be negative and/or the signals may be coupled to inverting input(s) of the amplifiers 4102' and/or 4104'.

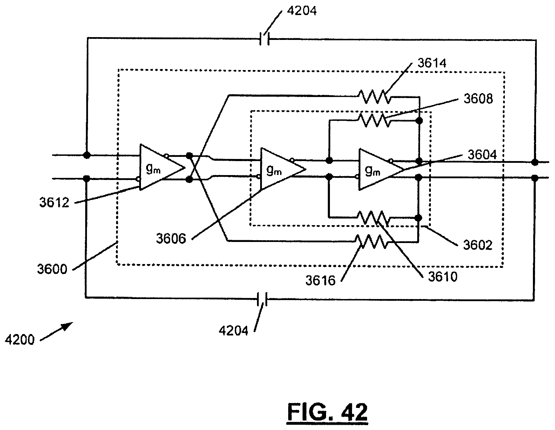

Referring now to FIG. 42, an integrator 4200 that is formed using a nested transimpedance amplifier is illustrated. This example is identical to the double-nested transimpedance amplifier illustrated in FIG. 37, except that resistances 3704 and 3705 have been replaced with capacitances 4202 and 4204.

The integrator 4200 has a high bandwidth due to the transimpedance configuration. The impedance output is low even at high frequencies. Because of the low output impedance, the integrator 4200 may be useful to drive large capacitive loads. One application of the integrator 4200 may be in a Sigma-Delta analog-to-digital converter that operates at gigahertz over sampling frequencies.

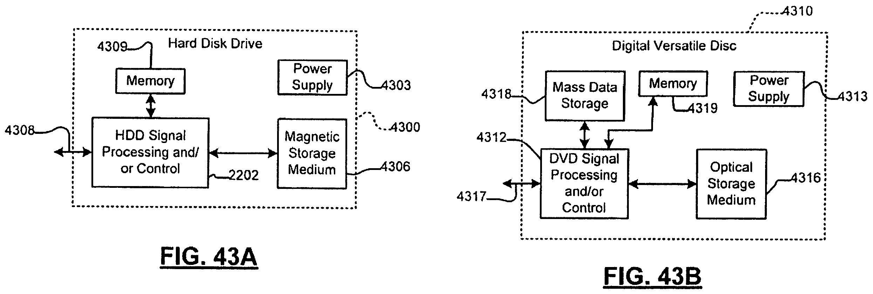

Referring now to FIGs. 43A-43G, various exemplary implementations of the present disclosure are shown. Referring now to FIG. 43A, the present disclosure can be implemented in amplifiers and/or integrators of a hard disk drive 4300. The present disclosure may implement and/or be implemented in either or both signal processing and/or control circuits and/or a power supply 4303, which are generally identified in FIG. 43A at 4302. In some implementations, the signal processing and/or control circuit 4302 and/or other circuits (not shown) in the HDD 4300 may process data, perform coding and/or encryption, perform calculations, and/or format data that is output to and/or received from a magnetic storage medium 4306.

The HDD 4300 may communicate with a host device (not shown) such as a computer, mobile computing devices such as personal digital assistants, cellular phones, media or MP3 players and the like, and/or other devices via one or more wired or wireless communication links 4308. The HDD 4300 may be connected to memory 4309 such as random access memory (RAM), low latency nonvolatile memory such as flash memory, read only memory (ROM) and/or other suitable electronic data storage.

Referring now to FIG. 43B, the present disclosure can be implemented in amplifiers and/or integrators of a digital versatile disc (DVD) drive 4310. The present disclosure may implement and/or be implemented in either or both signal processing and/or control circuits, which are generally identified in FIG. 43B at 4312, mass data storage of the DVD drive 4310 and/or a power supply 4313. The signal processing and/or control circuit 4312 and/or other circuits (not shown) in the DVD 4310 may process data, perform coding and/or encryption, perform calculations, and/or format data that is read from and/or data written to an optical storage medium 4316. In some implementations, the signal processing and/or control circuit 4312 and/or other circuits (not shown) in the DVD 4310 can also perform other functions such as encoding and/or decoding and/or any other signal processing functions associated with a DVD drive.

The DVD drive 4310 may communicate with an output device (not shown) such as a computer, television or other device via one or more wired or wireless communication links 4317. The DVD 4310 may communicate with mass data storage 4318 that stores data in a nonvolatile manner. The mass data storage 4318 may include a hard disk drive (HDD). The HDD may have the configuration shown in FIG. 43A. The HDD may be a mini HDD that includes one or more platters having a diameter that is smaller than approximately 1.8". The DVD 4310 may be connected to memory 4319 such as RAM, ROM, low latency nonvolatile memory such as flash memory and/or other suitable electronic data storage.

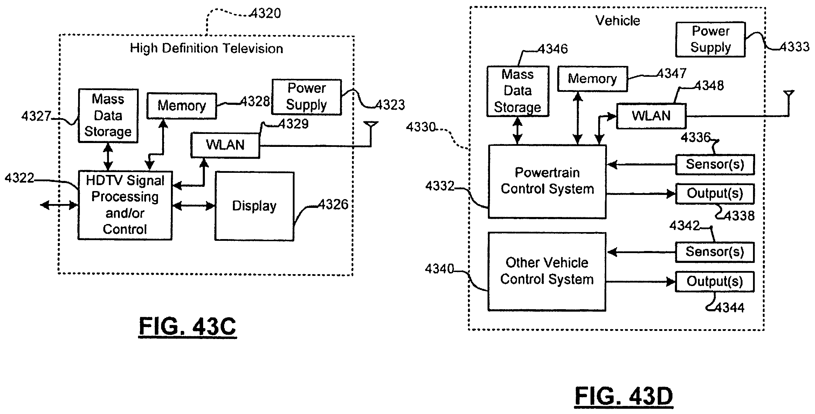

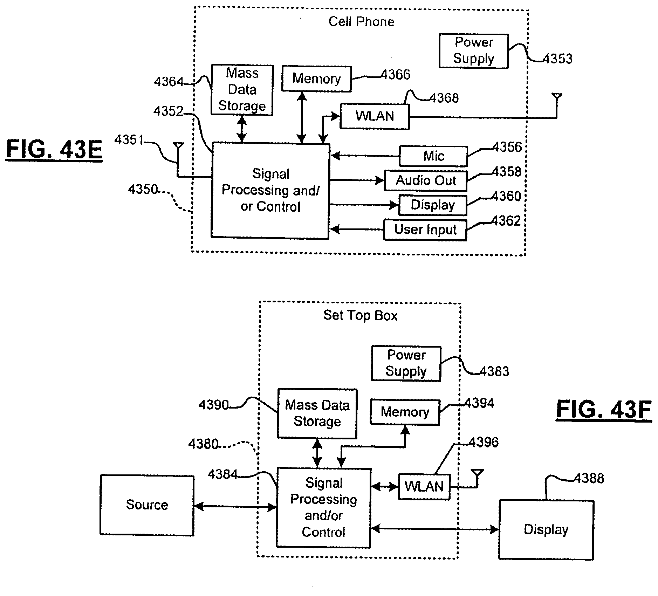

Referring now to FIG. 43C, the present disclosure can be implemented in amplifiers and/or integrators of a high definition television (HDTV) 4320. The present disclosure may implement and/or be implemented in either or both signal processing and/or control circuits, which are generally identified in FIG. 43E at 4322, a WLAN interface, mass data storage of the HDTV 4320 and/or a power supply 4323. The HDTV 4320 receives HDTV input signals in either a wired or wireless format and generates HDTV output signals for a display 4326. In some implementations, signal processing circuit and/or control circuit 4322 and/or other circuits (not shown) of the HDTV 4320 may process data, perform coding and/or encryption, perform calculations, format data and/or perform any other type of HDTV processing that may be required.

The HDTV 4320 may communicate with mass data storage 4327 that stores data in a nonvolatile manner such as optical and/or magnetic storage devices. At least one HDD may have the configuration shown in FIG. 43A and/or at least one DVD may have the configuration shown in FIG. 43B. The HDD may be a mini HDD that includes one or more platters having a diameter that is smaller than approximately 1.8". The HDTV 4320 may be connected to memory 4328 such as RAM, ROM, low latency nonvolatile memory such as flash memory and/or other suitable electronic data storage. The HDTV 4320 also may support connections with a WLAN via a WLAN network interface 4329.

Referring now to FIG. 43D, the present disclosure may implement and/or be implemented in amplifiers and/or integrators of a control system of a vehicle 4330, a WLAN interface, mass data storage of the vehicle control system and/or a power supply 4333. In some implementations, the present disclosure implement a powertrain control system 4332 that receives inputs from one or more sensors such as temperature sensors, pressure sensors, rotational sensors, airflow sensors and/or any other suitable sensors and/or that generates one or more output control signals such as engine operating parameters, transmission operating parameters, and/or other control signals.

The present disclosure may also be implemented in other control systems 4340 of the vehicle 4330. The control system 4340 may likewise receive signals from input sensors 4342 and/or output control signals to one or more output devices 4344. In some implementations, the control system 4340 may be part of an anti-lock braking system (ABS), a navigation system, a telematics system, a vehicle telematics system, a lane departure system, an adaptive cruise control system, a vehicle entertainment system such as a stereo, DVD, compact disc and the like. Still other implementations are contemplated.

The powertrain control system 4332 may communicate with mass data storage 4346 that stores data in a nonvolatile manner. The mass data storage 4346 may include optical and/or magnetic storage devices for example hard disk drives HDD and/or DVDs. At least one HDD may have the configuration shown in FIG. 43A and/or at least one DVD may have the configuration shown in FIG. 43B. The HDD may be a mini HDD that includes one or more platters having a diameter that is smaller than approximately 1.8". The powertrain control system 4332 may be connected to memory 4347 such as RAM, ROM, low latency nonvolatile memory such as flash memory and/or other suitable electronic data storage. The powertrain control system 4332 also may support connections with a WLAN via a WLAN network interface 4348. The control system 4340 may also include mass data storage, memory and/or a WLAN interface (all not shown).

Referring now to FIG. 43E, the present disclosure can be implemented in amplifiers and/or integrators of a cellular phone 4350 that may include a cellular antenna 4351. The present disclosure may implement and/or be implemented in either or both signal processing and/or control circuits, which are generally identified in FIG. 43E at 4352, a WLAN interface, mass data storage of the cellular phone 4350 and/or a power supply 4353. In some implementations, the cellular phone 4350 includes a microphone 4356, an audio output 4358 such as a speaker and/or audio output jack, a display 4360 and/or an input device 4362 such as a keypad, pointing device, voice actuation and/or other input device. The signal processing and/or control circuits 4352 and/or other circuits (not shown) in the cellular phone 4350 may process data, perform coding and/or encryption, perform calculations, format data and/or perform other cellular phone functions.

The cellular phone 4350 may communicate with mass data storage 4364 that stores data in a nonvolatile manner such as optical and/or magnetic storage devices for example hard disk drives HDD and/or DVDs. At least one HDD may have the configuration shown in FIG. 43A and/or at least one DVD may have the configuration shown in FIG. 43B. The HDD may be a mini HDD that includes one or more platters having a diameter that is smaller than approximately 1.8". The cellular phone 4350 may be connected to memory 4366 such as RAM, ROM, low latency nonvolatile memory such as flash memory and/or other suitable electronic data storage. The cellular phone 4350 also may support connections with a WLAN via a WLAN network interface 4368.

Referring now to FIG. 43F, the present disclosure can be implemented in amplifiers and/or integrators of a set top box 4380. The present disclosure may implement and/or be implemented in either or both signal processing and/or control circuits, which are generally identified in FIG. 43F at 4384, a WLAN interface, mass data storage of the set top box 4380 and/or a power supply 4383. The set top box 4380 receives signals from a source such as a broadband source and outputs standard and/or high definition audio/video signals suitable for a display 4388 such as a television and/or monitor and/or other video and/or audio output devices. The signal processing and/or control circuits 4384 and/or other circuits (not shown) of the set top box 4380 may process data, perform coding and/or encryption, perform calculations, format data and/or perform any other set top box function.

The set top box 4380 may communicate with mass data storage 4390 that stores data in a nonvolatile manner. The mass data storage 4390 may include optical and/or magnetic storage devices for example hard disk drives HDD and/or DVDs. At least one HDD may have the configuration shown in FIG. 43A and/or at least one DVD may have the configuration shown in FIG. 43B. The HDD may be a mini HDD that includes one or more platters having a diameter that is smaller than approximately 1.8". The set top box 4380 may be connected to memory 4394 such as RAM, ROM, low latency nonvolatile memory such as flash memory and/or other suitable electronic data storage. The set top box 4380 also may support connections with a WLAN via a WLAN network interface 4396.

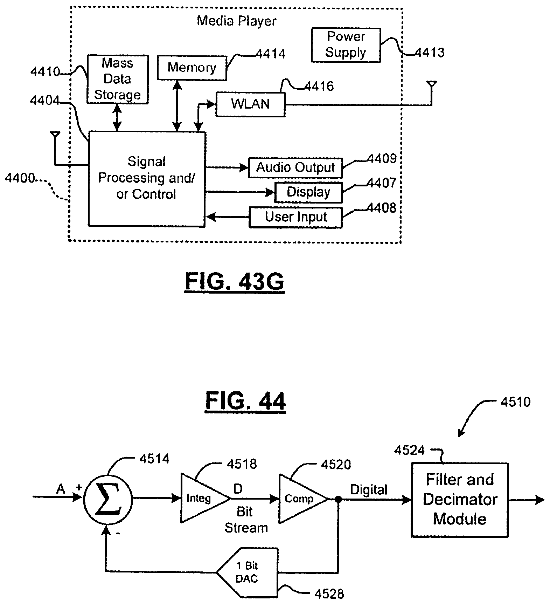

Referring now to FIG. 43G, the present disclosure can be implemented in amplifiers and/or integrators of a media player 4400. The present disclosure may implement and/or be implemented in either or both signal processing and/or control circuits, which are generally identified in FIG. 43G at 4404, a WLAN interface, mass data storage of the media player 4400 and/or a power supply 4403. In some implementations, the media player 4400 includes a display 4407 and/or a user input 4408 such as a keypad, touchpad and the like. In some implementations, the media player 4400 may employ a graphical user interface (GUI) that typically employs menus, drop down menus, icons and/or a point-and-click interface via the display 4407 and/or user input 4408. The media player 4400 further includes an audio output 4409 such as a speaker and/or audio output jack. The signal processing and/or control circuits 4404 and/or other circuits (not shown) of the media player 4400 may process data, perform coding and/or encryption, perform calculations, format data and/or perform any other media player function.

The media player 4400 may communicate with mass data storage 4410 that stores data such as compressed audio and/or video content in a nonvolatile manner. In some implementations, the compressed audio files include files that are compliant with MP3 format or other suitable compressed audio and/or video formats. The mass data storage may include optical and/or magnetic storage devices for example hard disk drives HDD and/or DVDs. At least one HDD may have the configuration shown in FIG. 43A and/or at least one DVD may have the configuration shown in FIG. 43B. The HDD may be a mini HDD that includes one or more platters having a diameter that is smaller than approximately 1.8". The media player 4400 may be connected to memory 4414 such as RAM, ROM, low latency nonvolatile memory such as flash memory and/or other suitable electronic data storage. The media player 4400 also may support connections with a WLAN via a WLAN network interface 4416. Still other implementations in addition to those described above are contemplated.

Referring now to FIG. 44, a Sigma Delta analog to digital converter (ADC) module 4510 is shown. The Sigma Delta ADC module 2810 includes a difference amplifier module 4514 that receives an analog input signal. An output of the difference amplifier module 4514 is input to an integrator module 4518. An output of the integrator module 4518 is one input of a comparator module 4520. Another input of the comparator module 4520 may be connected to a reference potential such as ground. An output of the comparator module 4520 is input to a filter and decimator module 4524, which outputs a digital signal. The output of the comparator module 4520 is input to a digital to analog converter (DAC) module 4528. The DAC module 4528 may be a 1-bit DAC. An output of the DAC module 4528 is input to an inverting input of the difference amplifier module 4514.

In use, the output of the DAC module 4528 is subtracted from the input signal. The resulting signal is integrated by the integrator module 4518. The integrator output voltage is converted to a single bit digital output (1 or 0) by the comparator module 4520. The resulting bit becomes an input to the DAC module 4528. This closed-loop process may be carried out at a very high oversampled rate. The digital data output by the comparator module is a stream of ones and zeros and the value of the signal is proportional to the density of ones output by the comparator module. For an increasing value, the density of ones increases. For a decreasing value, the density of ones decreases. By summing the error voltage, the integrator acts as a lowpass filter to the input signal and a highpass filter to the quantization noise. The bit stream is digitally filtered by the filter and decimator module to provide a binary-format output.

As can be appreciated, the TIA amplifiers described in the embodiments set forth above may be used to implement one or more of the difference amplifier module, the integrator module and the comparator module in the Sigma Delta DAC module.

Those skilled in the art can now appreciate from the foregoing description that the broad teachings of the present invention can be implemented in a variety of forms. Therefore, while this invention has been described in connection with particular examples thereof, the true scope of the invention should not be so limited since other modifications will become apparent to the skilled practitioner upon a study of the drawings, the specification and the following, without departing from the scope of the invention as set forth in the appended claims.

## Claims

1. A differential transimpedance amplifier circuit comprising:
a first operational amplifier having a first inverting input, a first non-inverting input, a first inverting output and a first non-inverting output;
a second operational amplifier having a second inverting input, a second non-inverting input, a second inverting output and a second non-inverting output, wherein said second inverting output is connected to the first non-inverting input and the second non-inverting output is connected to the first inverting input;
a third operational amplifier having a third inverting input, a third non-inverting input, a third inverting output and a third non-inverting output, wherein the second inverting input is connected to the third non-inverting output and the second non-inverting input is connected to the third inverting output;
a fourth operational amplifier having a fourth inverting input, a fourth non-inverting input, a fourth inverting output and a fourth non-inverting output, wherein the fourth inverting output is connected to the third non-inverting input and the fourth non-inverting output is connected to the third inverting input;
a first feedback element that is connected to the second non-inverting input and the second inverting output;
a second feedback element that is connected to the second inverting input and the second non-inverting output;
a third feedback element that is connected to the third non-inverting input and the first inverting output;
a fourth feedback element that is connected to the third inverting input and the first non-inverting output;
a fifth feedback element that is connected to the fourth inverting input and the first inverting output; and
a sixth feedback element that is connected to the fourth non-inverting input and the first non-inverting output.

2. The differential transimpedance amplifier circuit of claim 1 wherein the first and second feedback elements comprise first and second resistances, respectively.

3. The differential transimpedance amplifier circuit of claim 1 or 2 wherein the third and fourth feedback elements comprise first and second resistances, respectively.

4. The differential transimpedance amplifier circuit of any of claims 1 to 3 wherein the fifth and sixth feedback elements comprises first and second resistances, respectively.

5. A Sigma-Delta analog to digital converter comprising the differential transimpedance amplifier circuit of any of claims 1 to 4.

## Patentansprüche

1. Differentielle Transimpedanzverstärkerschaltung, umfassend:
einen ersten Operationsverstärker mit einem ersten invertierenden Eingang, einem ersten nichtinvertierenden Eingang, einem ersten invertierenden Ausgang und einem ersten nichtinvertierenden Ausgang;
einen zweiten Operationsverstärker mit einem zweiten invertierenden Eingang, einem zweiten nichtinvertierenden Eingang, einem zweiten invertierenden Ausgang und einem zweiten nichtinvertierenden Ausgang, wobei der zweite invertierende Ausgang mit dem ersten nichtinvertierenden Eingang verbunden ist und der zweite nichtinvertierende Ausgang mit dem ersten invertierenden Eingang verbunden ist;
einen dritten Operationsverstärker mit einem dritten invertierenden Eingang, einem dritten nichtinvertierenden Eingang, einem dritten invertierenden Ausgang und einem dritten nichtinvertierenden Ausgang, wobei der zweite invertierende Eingang mit dem dritten nichtinvertierenden Ausgang verbunden ist und der zweite nichtinvertierende Eingang mit dem dritten invertierenden Ausgang verbunden ist;
einen vierten Operationsverstärker mit einem vierten invertierenden Eingang, einem vierten nichtinvertierenden Eingang, einem vierten invertierenden Ausgang und einem vierten nichtinvertierenden Ausgang, wobei der vierte invertierende Ausgang mit dem dritten nichtinvertierenden Eingang verbunden ist und der vierte nichtinvertierende Ausgang mit dem dritten invertierenden Eingang verbunden ist;
ein erstes Feedback-Element, das mit dem zweiten nichtinvertierenden Eingang und dem zweiten invertierenden Ausgang verbunden ist;
ein zweites Feedback-Element, das mit dem zweiten invertierenden Eingang und dem zweiten nichtinvertierenden Ausgang verbunden ist;
ein drittes Feedback-Element, das mit dem dritten nichtinvertierenden Eingang und dem ersten invertierenden Ausgang verbunden ist;
ein viertes Feedback-Element, das mit dem dritten invertierenden Eingang und dem ersten nichtinvertierenden Ausgang verbunden ist;
ein fünftes Feedback-Element, das mit dem vierten invertierenden Eingang und dem ersten invertierenden Ausgang verbunden ist; und
ein sechstes Feedback-Element, das mit dem vierten nichtinvertierenden Eingang und dem ersten nichtinvertierenden Ausgang verbunden ist.

2. Differentielle Transimpedanzverstärkerschaltung nach Anspruch 1, wobei die ersten und zweiten Feedback-Elemente erste bzw. zweite Widerstände umfassen.

3. Differentielle Transimpedanzverstärkerschaltung nach Anspruch 1 oder 2, wobei die dritten und vierten Feedback-Elemente erste bzw. zweite Widerstände umfassen.

4. Differentielle Transimpedanzverstärkerschaltung nach einem der Ansprüche 1 bis 3, wobei die fünften und sechsten Feedback-Elemente erste bzw. zweite Widerstände umfassen.

5. Sigma-Delta-Analog-Digital-Wandler, der die differentielle Transimpedanzverstärkerschaltung nach einem der Ansprüche 1 bis 4 umfasst.

## Revendications

1. Circuit amplificateur transimpédance différentiel comprenant :
un premier amplificateur opérationnel ayant une première entrée inverseuse, une première entrée non inverseuse, une première sortie inverseuse et une première sortie non inverseuse ;
un deuxième amplificateur opérationnel ayant une deuxième entrée inverseuse, une deuxième entrée non inverseuse, une deuxième sortie inverseuse et une deuxième sortie non inverseuse, dans lequel ladite deuxième sortie inverseuse est connectée à la première entrée non inverseuse et la deuxième sortie non inverseuse est connectée à la première entrée inverseuse ;
un troisième amplificateur opérationnel ayant une troisième entrée inverseuse, une troisième entrée non inverseuse, une troisième sortie inverseuse et une troisième sortie non inverseuse, dans lequel la deuxième entrée inverseuse est connectée à la troisième sortie non inverseuse et la deuxième entrée non inverseuse est connectée à la troisième sortie inverseuse ;
un quatrième amplificateur opérationnel ayant une quatrième entrée inverseuse, une quatrième entrée non inverseuse, une quatrième sortie inverseuse et une quatrième sortie non inverseuse, dans lequel la quatrième sortie inverseuse est connectée à la troisième entrée non inverseuse et la deuxième sortie non inverseuse est connectée à la troisième entrée inverseuse ;
un premier élément de rétroaction qui est connecté à la deuxième entrée non inverseuse et à la deuxième sortie inverseuse ;
un deuxième élément de rétroaction qui est connecté à la deuxième entrée inverseuse et à la deuxième sortie non inverseuse ;
un troisième élément de rétroaction qui est connecté à la troisième entrée non inverseuse et à la première sortie inverseuse ;
un quatrième élément de rétroaction qui est connecté à la troisième entrée inverseuse et à la première sortie non inverseuse ;
un cinquième élément de rétroaction qui est connecté à la quatrième entrée inverseuse et à la première sortie inverseuse ; et
un sixième élément de rétroaction qui est connecté à la quatrième entrée non inverseuse et à la première sortie non inverseuse.

2. Circuit amplificateur transimpédance différentiel selon la revendication 1 dans lequel les premier et deuxième éléments de rétroaction comprennent respectivement des première et deuxième résistances.

3. Circuit amplificateur transimpédance différentiel selon la revendication 1 ou dans lequel les troisième et quatrième éléments de rétroaction comprennent respectivement des première et deuxième résistances.

4. Circuit amplificateur transimpédance différentiel selon l'une quelconque des revendications 1 à 3 dans lequel les cinquième et sixième éléments de rétroaction comprennent respectivement des première et deuxième résistances.

5. Convertisseur analogique-numérique Sigma-Delta comprenant le circuit amplificateur transimpédance différentiel selon l'une quelconque des revendications 1 à 4.
